# EUROPÄISCHE PATENTSCHRIFT

(11) **EP 1 387 897 B1**
(45) Veröffentlichungstag und Bekanntmachung des Hinweises auf die Patenterteilung: **16.08.2006**
(21) Anmeldenummer: 02740294.0
(22) Anmeldetag: 26.04.2002
(51) Int. Cl.: C23C 14/35, H01J 37/34

(54) **ELEKTRODENANORDNUNG FÜR DIE MAGNETFELDGEFÜHRTE PLASMAGESTÜTZTE ABSCHEIDUNG DÜNNER SCHICHTEN IM VAKUUM**
ELECTRODE ARRANGEMENT FOR THE PLASMA-SUPPORTED MAGNETICALLY-GUIDED DEPOSITION OF THIN LAYERS IN VACUO
ENSEMBLE D'ELECTRODES POUR DEPOT SOUS VIDE A SOUTIEN PLASMIQUE, GUIDE PAR CHAMP MAGNETIQUE, DE COUCHES MINCES

(30) Priorität: 09.05.2001 DE 10122431
(43) Veröffentlichungstag der Anmeldung: 11.02.2004
(73) Patentinhaber: Fraunhofer-Gesellschaft zur Förderung der angewandten Forschung e.V., 80686 München (DE)
(72) Erfinder: WINKLER, Torsten, 01454 Radeberg (DE); WEISKE, Dieter, 01239 Dresden (DE); EGEL, Manuela, 01324 Dresden (DE); GOEDICKE, Klaus, 01307 Dresden (DE); KIRCHHOFF, Volker, 01234 Dresden (DE); LIEBIG, Jörn-Steffen, 01328 Dresden, OT Malschendorf (DE); KOPTE, Torsten, 01731 Kreischa (DE)
(86) Internationale Anmeldenummer: PCT/DE2002/001534
(87) Internationale Veröffentlichungsnummer: WO 2002/090612

(56) Entgegenhaltungen:
- DD-A- 252 205
- DE-A- 19 617 057
- DE-A- 19 756 162
- DE-U- 29 823 900

## Beschreibung

Die Erfindung betrifft eine Anordnung aus mehreren längserstreckten Elektroden für die magnetfeldgeführte plasmagestützte Abscheidung dünner Schichten im Vakuum. Sie findet Anwendung in der Zerstäubungs- oder Sputtertechnik; dazu werden die Elektroden mit dem zu zerstäubenden Material in Form sogenannter Targets belegt. Die Elektrodenanordnung findet darüber hinaus auch Anwendung bei der magnetfeldverstärkten chemischen Dampfphasenabscheidung (chemical vapour deposition - CVD), der Plasmapolymerisation und anderen plasmaaktivierten Vakuumbeschichtungsverfahren.

Die weiteste Verbreitung finden derartige Anordnungen mit längserstreckten Elektroden beim Magnetronzerstäuben mit sogenannten Doppelmagnetroneinrichtungen. Derartige Doppelmagnetroneinrichtungen werden vorwiegend für die Abscheidung von isolierenden Schichten mittels reaktiven Zerstäubens metallischer Targets in einer Reaktivgasathmosphäre eingesetzt. Die Abscheidung der dünnen Schichten bzw. die Zerstäubung der Targets erfolgt dabei vorzugsweise durch mittelfrequent gepulste Energieeinspeisung in eine Niederdruckgasentladung unter Verwendung besagter längserstreckter Elektroden. Wird die Energieeinspeisung bipolar vorgenommen, so werden die Targets auf nebeneinander liegenden längserstreckten Elektroden abwechselnd im Takt der Pulsfrequenz abgestäubt, wobei der überwiegende Teil des Materialabtrages in Targetbereichen erfolgt auf denen sich parallel verlaufende Sputtergräben ausbilden, die von tunnelförmigen Magnetfeldern überwölbt werden. Die Nutzung der beschriebenen Elektrodenanordnungen ist auch bekannt geworden für die Speisung der Gasentladung durch zwei voneinander unabhängige Gleichstromquellen (May, Strümpfel, Coating on Glass: ITO coating by reactive magnetron sputtering-comparison of properties from DC and MF processing).

Es sind Doppelmagnetroneinrichtungen bekannt, die aus zwei längs nebeneinander angeordneten gleichartigen Magnetrons bestehen (DE 41 06 770, DE 40 42 287, DE 195 08 405).
Diese Patente beschreiben gleichzeitig den typischen Aufbau von Doppelmagnetroneinrichtungen, der in einer parallelen Anordnung zweier unabhängiger Magnetronbaugruppen besteht.

Es besteht das Ziel, den Abstand zwischen den Elektroden möglichst gering zu halten, um die Anforderungen an die Größe der Vakuumkammer zu begrenzen. Dieses Ziel ist auch verfahrenstechnisch begründet, weil eine räumliche Trennung der beiden durch das Zerstäuben von Targets auf den Elektroden entstehenden Dampfwolken unerwünscht ist, da ansonsten die Gleichmäßigkeit abgeschiedener Schichten bzw. der Wirkung des Zerstäubungsplasmas verschlechtert wird.
Es ist bekannt, dass der Annäherung der Elektroden oftmals bauartbedingte Grenzen gesetzt sind (DE 41 06 770). So sorgen beispielsweise Isolatoren für den Elektrodengrundkörper und der erforderliche Kammersteg zwischen beiden Magnetrons dafür, dass diese Anforderung nach einem engen Abstand der beiden Elektroden nicht erfüllt werden kann.
Es ist weiterhin bekannt, dass andere Elektrodenanordnungen bauartbedingt eine engere Annäherung der Elektroden ermöglichen (DE 40 42 287). In diesem Falle würde jedoch durch Überlagerung der magnetischen Felder der beiden Magnetrons zumindest im Bereich der parallel verlaufenden Sputtergräben ein resultierendes Magnetfeld entstehen, welches in den einander zugekehrten Bereichen der magnetischen Tunnel eine wesentlich höhere Feldstärke aufweist als in den einander abgewandten. Daraus resultieren unterschiedliche Plasmadichten und Erosionsraten. Das wiederum führt ebenfalls zu einer geringeren Schichtgleichmäßigkeit und einer verkürzten mittleren Targetstandzeit, da sich ein Wechsel bereits erforderlich macht, wenn die wenigen am stärksten erodierten Targets unbrauchbar sind.
Es ist bekannt, eine magnetisch leitfähige Wand zwischen den Magnetrons einzuführen, welche die Verkopplung der magnetischen Felder im Bereich der magnetfelderzeugenden Baugruppen verringern kann (DE 196 17 057 , DE 298 23 900). Diese Lösung ist in dahingehend erweitert worden, dass spezielle Gasleiteinrichtungen zwischen den Elektroden aus weichmagnetischen Hohlprofilen gestaltet werden (DE 197 56 162). Die Verwendung derartiger magnetisch leitfähiger Zwischenwände führt jedoch zur Schwächung des Magnetfeldes oberhalb der Elektroden- bzw. Targetoberfläche. Da keine Verschlechterung der elektrischen Parameter der Gasentladung hingenommen werden kann, muss das Volumen der magnetfelderzeugenden Teile und damit der technische Aufwand erhöht werden, um die Verluste zu kompensieren.

Es ist weiterhin bekannt, zusätzlich zu den magnetischen Schirmwänden speziell geformte weichmagnetische Bauteile unterhalb der Targets anzuordnen, um die Plasmadichteverteilung und damit die Erosion der Targets gleichmäßiger zu gestalten (DE 196 17 057). Dies führt jedoch ebenfalls zur Ausbildung eines verlustreichen Magnetkreises.

Die sich aus dem Stand der Technik ergebenden Probleme bei einer parallelen Anordnung zweier Magnetronbaugruppen treten in ähnlicher Weise bei der parallelen Anordnung weiterer Magnetronbaugruppen auf.

Aufgabe der vorliegenden Erfindung ist es deshalb, eine Elektrodenanordnung für die magnetfeldgeführte plasmagestützte Abscheidung von dünnen Schichten im Vakuum mit mehreren dicht nebeneinander angeordneten längserstreckten Elektroden anzugeben, mit der eine hohe Gleichmäßigkeit der Plasmadichteverteilung erreicht werden kann, ohne verlustreiche Magnetkreise einsetzen zu müssen. Bei einer Belegung der Elektroden mit Targets zum Zweck des Zerstäubens sollen die Erosionsgräben möglichst das gleiche Erosionsprofil und die gleiche Erosionsgeschwindigkeit haben, um eine hohe Targetausnutzung zu gewährleisten.

Die Aufgabe wird erfindungsgemäß durch Elektroden mit Merkmalen gemäß Anspruch 1 gelöst. Die Merkmale der Ansprüche 2 bis 13 stellen zweckmäßige Ausgestaltungen der erfindungsgemäßen Einrichtung dar.

Das Wesen der Erfindung besteht darin, Anordnungen aus mehreren nebeneinander angeordneten längserstreckten Elektroden als untrennbaren Einzelbaugruppe zu betrachten und zu optimieren.
Der Aufbau und die Optimierung herkömmlicher längserstreckter Elektrodenanordnungen in der Zerstäubungstechnik erfolgte nach dem Stand der Technik stets so, dass zunächst versucht wurde, ein möglichst gut an die Erfordernisse der Einzelelektrode angepasstes Magnetfeld zu erzeugen, welches bei einer evtl. erforderlichen dichten Annäherung mehrerer Elektroden durch verlustreiche Abschirmungen von der Nachbarelektrode ferngehalten werden musste. Zahlreiche Elektroden werden jedoch niemals einzeln, sondern stets im Zusammenspiel mit anderen Elektroden betrieben. Für all diese stellt die geschilderte Vorgehensweise einen erheblichen technischen Umweg dar.
Aus diesem Grunde wird bei der Anordnung mehrerer längserstreckter Elektroden in geringem Abstand erfindungsgemäß auf die Optimierung des Magnetfeldes für die Einzelelektrode verzichtet. Stattdessen wird das Magnetfeld so eingestellt, dass sich erst im montierten Zustand über der gesamten Anordnung, die aus mehreren längserstreckten Elektroden besteht, ein bezüglich der Gesamtanordnung optimiertes Magnetfeld ausbildet. Es wird also nicht die gegenseitige Abschirmung, sondern eine Superposition der einzelnen Magnetfelder angestrebt, weshalb Verluste durch zusätzliche Abschirmungen entfallen. Dennoch bilden sich Magnettunnel aus, in welchen zumindest im Bereich der nebeneinander verlaufenden geraden Zerstäubungsbereiche jeweils die gleiche Plasmadichteverteilung herrscht.

Insbesondere bei Doppelmagnetroneinrichtungen stellt die Erfindung eine erhebliche Vereinfachung dar. Auf eine Abstimmung der Magnetrons auf den Einzelbetrieb kann verzichtet werden.
Im Querschnitt quer zu ihrer Längsachse zeigt die Elektrodenanordnung für eine derartige Doppelmagnetroneinrichtung eine 5-polige magnetische Anordnung, wobei der mittlere Pol aus den einander zugewandten Außenpolen der beiden Elektroden gebildet werden kann. Das Magnetfeld für die Gesamtanordnung wird in diesem Fall durch eine bezüglich der Längsachse der Elektroden asymmetrische Gestaltung beider Hälften jeder Elektrode erzeugt. Die magnetische Feldstärke über den einander zugewandten Elektrodenbereichen ist deutlich geringer als über den äußeren Bereichen der Elektroden. Im montierten Zustand führt jedoch gerade diese asymmetrische Gestaltung der einzelnen Elektroden durch Superposition der einzelnen Magnetfelder zu einen symmetrischen Magnetfeld. Die Bemessung der magnetfelderzeugenden Teile und der die Magnetflüsse leitenden Teile erfolgt derart, dass sich für jeden der vier geraden parallel zueinander verlaufenden Zerstäubungsbereiche die gleiche Feldstärke und das gleiche Querprofil für die magnetische Feldstärke ergibt. Vorzugsweise werden zur Dimensionierung der Magnetkreise Berechnungsprogramme nach der Methode finiter Elemente benutzt, um dieses Gestaltungsprinzip zu verwirklichen. Im Fall der Anordnung weiterer paralleler Elektroden müssen nur die beiden äußeren Elektroden den beschriebenen asymmetrischen Verlauf der magnetischen Feldstärke aufweisen. Im Inneren der Anordnung befindliche Elektroden weisen ein symmetrisches Magnetfeld auf, das jeweils zum Rand der Elektrode hin abfällt. Dieser Randabfall der magnetischen Feldstärke wird wiederum durch Superposition der einzelnen Magnetfelder im montierten Zustand der gesamten Elektrodenanordnung aus mehreren parallelen längserstreckten Elektroden ausgeglichen.
Erfindungsgemäß kann damit keiner der längserstreckten Elektroden allein eine magnetfelderzeugende Einheit oder ein Teil von dieser zugeordnet werden, der im Fall des Zerstäubens für eine ausreichend gleichmäßige Ausprägung der magnetischen Tunnel über den geraden Bereichen der Erosionsgräben bei ausreichender magnetischer Feldstärke sorgt. Diese Anforderung an die Ausprägung des Magnetfeldes wird erst durch die magnetfelderzeugende Einheit der gesamten Anordnung aus mehreren dicht nebeneinander liegenden parallelen längserstreckten Elektroden im montierten Zustand erfüllt.

Als besonders vorteilhaft hat es sich bei Doppelmagnetronanordnungen erwiesen, wenn die Polstärken der jeweils mittleren Pole der einzelnen Elektroden in den geraden Bereichen der Magnettunnel gleich sind. Eine besonders vorteilhafte Bemessungsvorschrift beinhaltet weiterhin, dass sich die magnetische Feldstärke in den beiden Tunneln einer Elektrode zur magnetischen Feldstärke in den Tunneln der anderen Elektrode spiegelsymmetrisch verhält. Es ist besonders zweckmäßig, wenn in den geraden Bereichen der magnetischen Tunnel Polauflagen aus homogenem weichmagnetischem Material angeordnet sind, aber dass diese Polauflagen jedoch nicht mit den magnetfelderzeugenden Teilen in den sogenannten Kurvenbereichen bzw. den dort angeordneten Polauflagen magnetisch leitend verbunden sind. Auf diese Weise wird eine hohe Konstanz der magnetischen Feldstärke längs der geraden Stücke erreicht, und die geometriebedingten Einflüsse der Kurvenbereiche auf das Magnetfeld der geraden Bereiche werden unwirksam gemacht.
Eine in bezug auf Platzbedarf und Kosten besonders vorteilhafte Ausgestaltung der Erfindung wird erreicht, wenn üblicherweise als magnetischer Rückschluss wirkende Platten gleichzeitig die Trägerfunktion für die Elektroden übernehmen.
Befindet sich zwischen diesen Platten und den Elektroden eine elektrische Isolierung, wird der hochspannungsführende Teil der Einrichtung auf den unmittelbaren Bereich der Elektrodenflächen begrenzt. Weiterhin wird die Ausbildung unerwünschter elektrisch parallel geschalteter Gasentladungen verhindert, auch wenn die Einrichtung keine spezielle Dunkelfeldabschirmung aufweist.
Für die Stromzuführung zu den Elektroden können isoliert befestigte Federkontakte auf der der jeweiligen Elektrode zugewandten Seite der Platten vorgesehen werden. Sie erleichtern die Instandhaltung bzw. den Targetwechsel und stellen eine zuverlässige elektrische Verbindung der Elektroden mit der Stromversorgungseinrichtung sicher.
Eine besonders vorteilhafte Ausgestaltung der Erfindung beinhaltet weiterhin eine Folie aus weichmagnetischem Material an der Oberseite der Elektroden, die so bemessen ist, dass die zu den Elektrodenflächen senkrechte Komponente des magnetischen Feldes in der Ebene der Elektrodenoberflächen in jedem magnetischen Tunnel auf drei zueinander parallelen Linien gleich Null ist. Dadurch entstehen im Querprofil deutlich verbreitete Bereiche annähernd gleicher Plasmadichteverteilung bzw. auf den Targets breitgestreckte trogförmige Erosionsprofile, was eine gute Targetausnutzung gewährleistet.

Es ist zweckmäßig, das Magnetfeld durch Reihen nebeneinander angeordneter Permanentmagnete standardisierter Abmessungen mit Lücken geeigneter Breite aufzubauen, um die Magnetfeldstärke entsprechend der anzuwendenden Bemessungsvorschrift zu erzeugen.
Es ist weiterhin zweckmäßig, in den Kurvenbereichen anstelle von Polauflagen magnetfelderzeugende Teile zweireihig übereinander anzuordnen. Dadurch wird der Feldstärkeabfall in den Kurvenbereichen an den Enden der Elektroden, den Magnetronanordnungen nach dem Stand der Technik aufweisen, vermieden.
Eine besonders verlustarme Gestaltung der Magnetkreise wird erreicht, wenn die als magnetischer Rückschluss wirkenden Platten als Formteile in der Art einer Wanne ausgeführt sind, welche im Bereich der magnetfelderzeugenden Teile Erhebungen mit angeschrägten Übergängen zum Boden der Wanne aufweisen.
Insbesondere für Elektroden mit großen Abmessungen können die Platten aus einem flachen Trägerteil mit aufgesetzten angeschrägten Leisten gestaltet werden, um den Fertigungsaufwand zu reduzieren.
Besonders arm an magnetischen Feldverlusten sind Elektroden der erfindungsgemäßen Art, wenn die Rückschlussplatten durch ein einziges Bauteil ersetzt bzw. als ein gemeinsames, den magnetischen Rückschluss bewirkendes Bauteil ausgebildet sind. Im Fall des gemeinsamen Bauteils für den Rückschluss sind auch die beiden einander zugewandten Reihen von magnetfelderzeugenden Teilen der beiden Elektroden zu einer gemeinsamen Reihe entsprechender Polstärke entlang der Längsachse der gesamten Anordnung zusammengefasst.
Elektrodenanordnungen der beschriebenen Art zeichnen sich durch besonders geringe Breite aus. Der minimale Abstand zwischen den Elektroden kann bis auf 2 mm reduziert sein. Es sind keinerlei magnetische Schirmwände erforderlich. Infolge des sehr verlustarmen Aufbaus des magnetischen Kreises sind schmale magnetfelderzeugende Teile einsetzbar. Durch die geringe Polbreite ist das Magnetfeld im Bereich der Magnetpole stark fokussiert. Insgesamt bildet sich dadurch im Betrieb eine breite Zone hoher gleichmäßiger Plasmadichte bzw. ein breites Erosionsprofil im Falle des Zerstäubens aus, was eine hohe Targetausnutzung gewährleistet.

An einem Ausführungsbeispiel wird die Erfindung in ihrer Ausgestaltung für Doppelmagnetronsysteme näher erläutert. In den zugehörigen Zeichnungen zeigt:
- Fig. 1: eine Draufsicht auf eine erfindungsgemäße Einrichtung, wobei die Elektrodenplatten nicht dargestellt sind,
- Fig. 2: einen Längsschnitt durch eine erfindungsgemäße Einrichtung,

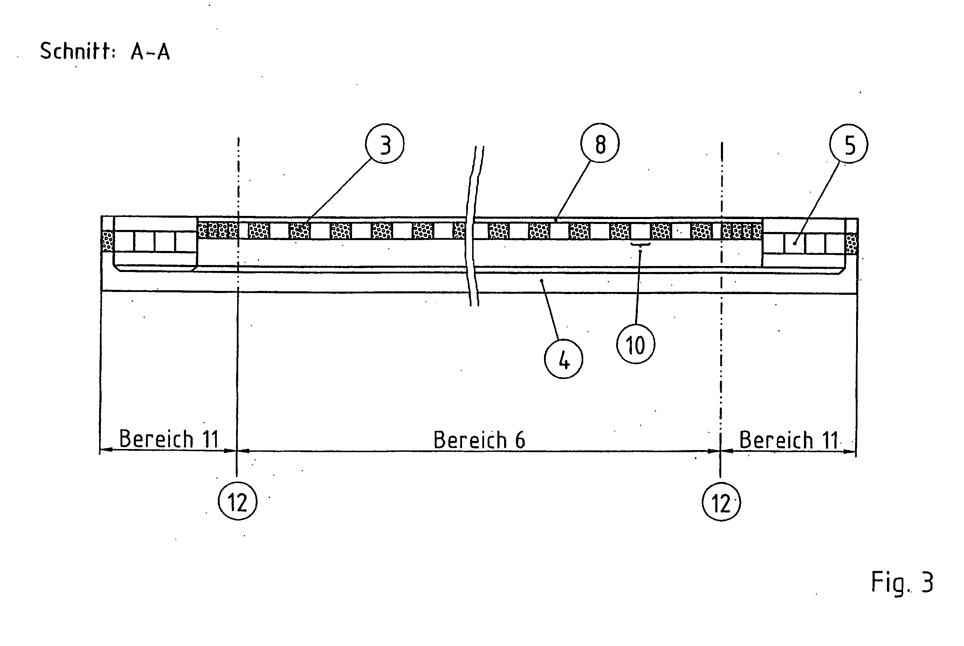

- Fig. 3: einen Querschnitt durch eine erfindungsgemäße Einrichtung,
- Fig. 4: einen Querschnitt durch die magnetfelderzeugende Baugruppe in einer Ausgestaltung mit einer gemeinsamen magnetischen Rückschlussplatte,
- Fig. 5: eine weitere Ausgestaltung der magnetfelderzeugenden Baugruppe.

In allen Figuren sind Bauteile zur Gewährleistung der Kühlung der Elektroden nicht dargestellt.

### Fig.1 bis 3

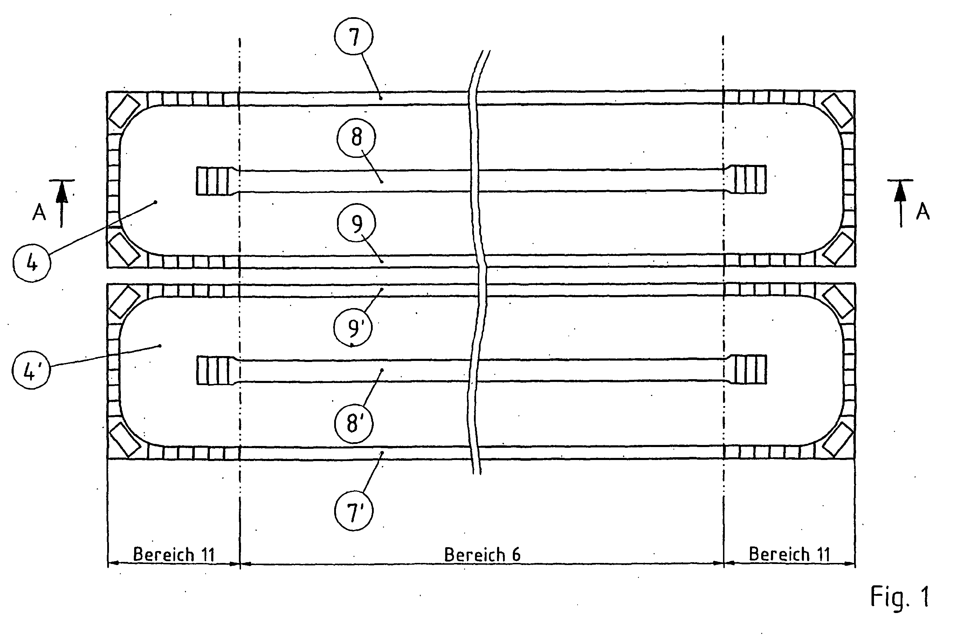

Die Einrichtung enthält magnetfelderzeugende Teile (1, 2, 3, 1', 2', 3'), die auf zwei spiegelsymmetrische Platten (4, 4') aufgesetzt sind. Ihr Profil weist im Bereich der aufgesetzten magnetfelderzeugenden Teile (1, 2, 3, 1', 2', 3') Erhebungen auf. Der Querschnitt der Erhebungen verjüngt sich bis zur Breite der magnetfelderzeugenden Teile (1, 2, 3, 1', 2', 3'). Alle magnetfelderzeugenden Teile (1, 2, 3, 1', 2', 3') bestehen aus einer SmCo-Legierung mit sehr hoher Koerzitivfeldstärke und hohem Energieprodukt. Die Länge der magnetfelderzeugenden Teile (1, 2, 3, 1', 2', 3') beträgt einheitlich 20 mm. Die Höhe der magnetfelderzeugenden Teile (1, 2, 3, 1', 2', 3') in Magnetisierungsrichtung beträgt im Beispiel 10 mm. Die Breite der magnetfelderzeugenden Teile (1, 2, 3, 1', 2', 3') ist erfindungsgemäß nicht einheitlich. Die Teile (1, 1') sind 8 mm breit, die Teile (2, 2') und die Teile (3, 3') sind 5 mm breit. Die magnetfelderzeugenden Teile in den Kurvenbereichen (5) sind zwischen 5 und 20 mm breit. Auf den magnetfelderzeugenden Teilen im geraden Bereich (6) sind Polauflagen (7, 8, 9, 7', 8', 9') aufgesetzt. Diese Polauflagen haben die Aufgabe, durch herstellungsbedingte Unterschiede in der magnetischen Feldstärke der einzelnen 20 mm langen magnetfelderzeugenden Teile verursachten Inhomogenitäten des Magnetfeldes in Längsrichtung auszugleichen. Die magnetfelderzeugenden Teile (3, 3') mit einer Breite von 5 mm sind mit Lücken (10) von durchschnittlich 6 mm aufgereiht. Über die Variation der Breite der Lücken von maximal ±2 mm ist der Feinabgleich der magnetischen Feldstärke oberhalb der Elektroden bzw. Targets ausgeführt. Die Kurven des sich ringförmig ausbildenden magnetischen Tunnels (Bereich 11 in Fig. 1) sind unabhängig von den geraden Teilen der Einrichtung dimensioniert. Durch die Verwendung von zweireihig übereinander angeordneten magnetfelderzeugenden Teilen ist das Magnetfeld in den Kurven so dimensioniert, dass beim Betreiben einer Gasentladung nur geringe Elektronenverluste in den Kurven auftreten können. An den Enden der Magnetpole (P2, P2') sind 4 magnetfelderzeugende Teile mit einer Breite von 8 mm angeordnet. In diesem Bereich wird keine Polauflage angeordnet, wodurch die Trennung des magnetischen Flusses zwischen den geraden Bereichen (6) und Kurvenbereichen (11) der Einrichtung scharf ausgebildet ist. An den Trennstellen (12) zwischen geradem Bereich (6) und den Kurvenbereichen (11) ist das magnetische Feld so dimensioniert, dass es an beiden Seiten der Trennstelle (12) gleich ist. Zum mechanischen Schutz und zur elektrischen Isolierung sind die magnetfelderzeugenden Baugruppen auf ihrer Oberseite mit U-Profilen (13) aus Kunststoff abgedeckt. Auf dem Boden der Platten (4, 4') sind alternierend die Baugruppen (14, 14') und (15, 15') montiert. Sie dienen der isolierten Befestigung der Elektrodenplatten (16, 16') und der Stromzuführung zu diesen Elektrodenplatten. Die Elektrodenplatten (16, 16') mit Targets (17, 17') sind so bemessen, dass sie in Länge und Breite im wesentlichen mit der Größe der magnetfelderzeugenden Baugruppen übereinstimmen. Auf der Oberseite der Elektrodenplatten (16, 16') sind 0,2 mm dicke Folien (18, 18') angeordnet. Sie bewirken, dass die zu den Targetplatten (17, 17') senkrecht stehende Komponente des Magnetfeldes in der Ebene der Targets in jedem Tunnel auf drei zueinander parallelen Linien Null ist.
Die gesamte Einrichtung zum Abscheiden von dünnen Schichten wird über Stützen (19) von innen an einen Vakuumflansch befestigt. In der Umgebung befinden sich ein Blendensystem mit Gaseinlasseinrichtung und gegenüber der Targets wird in einem Abstand von vorzugsweise 100 mm ... 150 mm ein Substrat zum Zweck der Beschichtung vorbeigeführt.

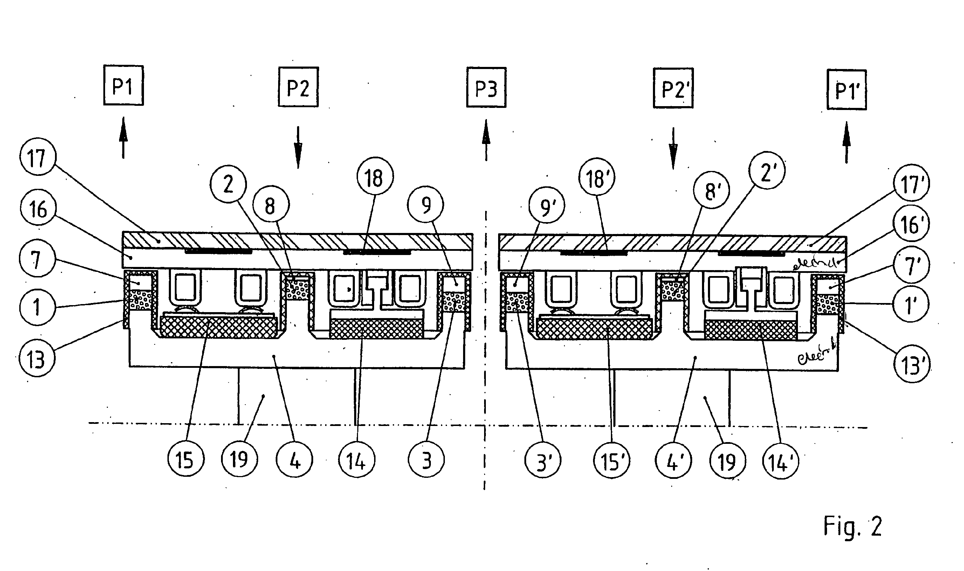

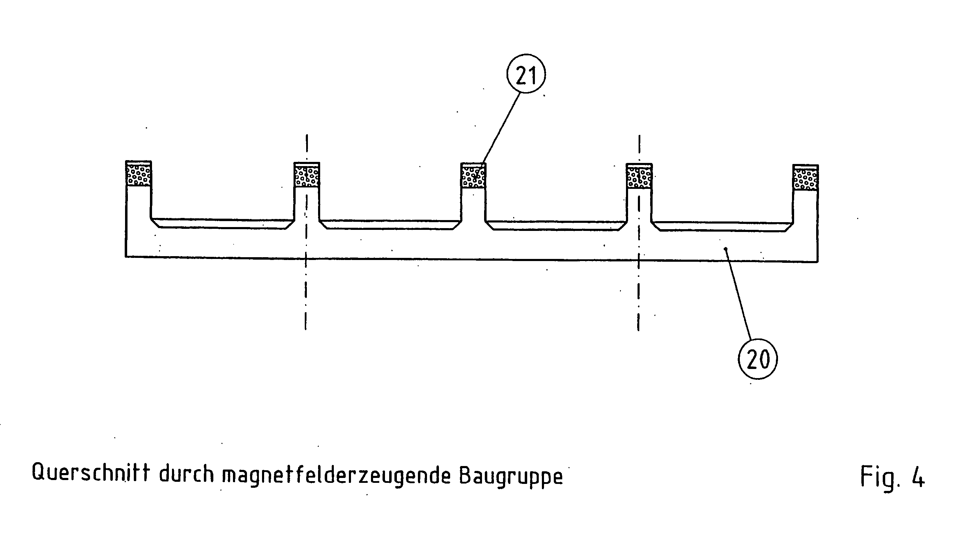

In Fig. 4 ist die magnetfelderzeugende Einrichtung einer Elektrodenanordnung dargestellt, bei der die Rückschlussplatten beider Magnetrons in Form einer gemeinsamen Platte (20) ausgebildet ist. Die einander zugewandten Reihen von magnetfelderzeugenden Teilen sind durch eine gemeinsame Reihe (21) von magnetfelderzeugenden Teilen ersetzt. Sie haben eine Länge von 20 mm, eine Höhe von 10 mm und eine Breite von 10 mm und wirken als gemeinsamer magnetischer Pol P3 (vgl. Fig. 2). Die gemeinsame Platte (20) hat außerdem die Funktion des Trägers für die gesamte Elektrodenanordnung.

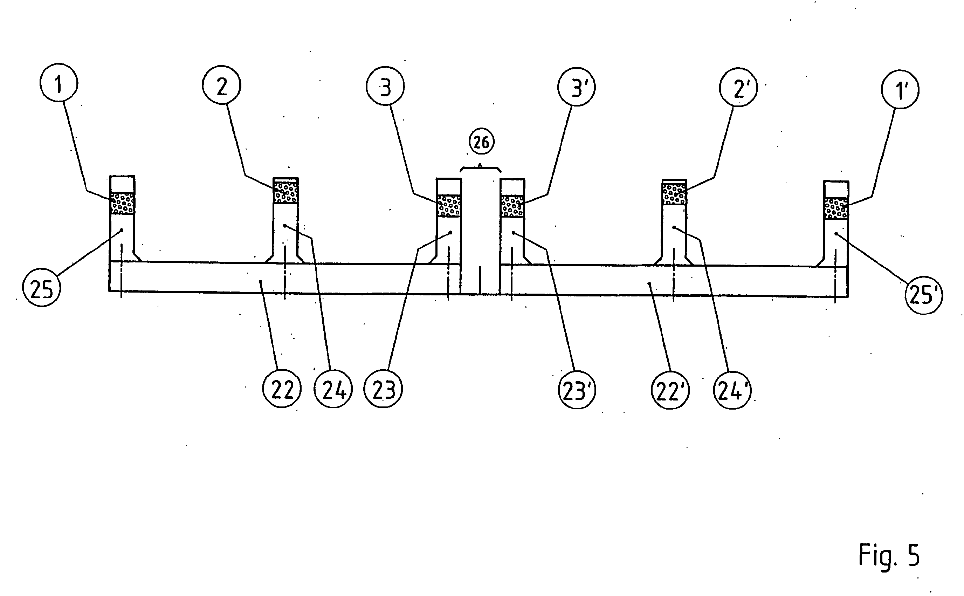

In Fig. 5 ist eine weitere technische Ausführung für den magnetischen Rückschluss einer Elektrodenanordnung veranschaulicht. Ebene Platten (22, 22') tragen Leisten (23, 24, 25, 23', 24', 25') mit angeschrägten Übergängen zu den Platten. Sie bestehen aus weichmagnetischem Material und weisen eine Breite auf, die der der zugehörigen magnetfelderzeugenden Teile (1, 2, 3, 1', 2', 3') entspricht. Die einander zugewandten Reihen von Leisten (23, 23') und Magneten (3, 3') beider Elektroden haben im Beispiel einen Abstand (26) von 6 mm und bilden einen gemeinsamen Magnetpol P3.

## Patentansprüche

1. Elektrodenanordnung zum magnetfeldgeführten plasmagestützten Abscheiden von dünnen Schichten im Vakuum mit mehreren parallelen längserstreckten Elektroden (4, 4'; 16, 16') mit das Magnetfeld erzeugenden und formenden Baugruppen aus Permanent-magneten (1-3; 1'-3') nach dem Prinzip des Magnetrons, die so dimensioniert sind, dass sich über parallel verlaufenden Elektrodenbereichen Magnettunnel mit im Wesentlichen gleichem Querschnitt und gleicher magnetischer Feldstärke ausbilden, wobei mindestens einer längserstreckten Elektrode (4) allein zumindest ein Teil einer magnetfelderzeugenden Einheit (1-3) zugeordnet ist, **dadurch gekennzeichnet, dass** der Teil derart ausgebildet ist, dass dessen sich in Längsrichtung der Elektrode erstreckende Permanentmagnetanordung (3) die an die magnetfetderzeugende Baugruppe (3') einer benachbarten Elektrode (4) angrenzt, ein schwächeres Magnetfeld aufweist als die weiter Außenliegende längserstreckte Permanentmagnetanordnung (1) auf der der benachbarten Elektrode gegenüberliegenden Seite, wobei der Teil derart gegenüber der benachbarten magnetfelderzeugenden Baugruppe angeordnet ist, dass im Fall des Zerstäubens nur durch Superposition mit den Magnetfeldern benachbarter magnetfelderzeugender Baugruppen anderer längserstreckter Elektroden für eine ausreichend gleichmäßige Ausprägung der magnetischen Tunnel über den geraden Bereichen der Erosionsgräben dieser längserstreckten Elektrode bei ausreichender magnetischer Feldstärke sorgt.

2. Einrichtung nach Anspruch 1, **dadurch gekennzeichnet, dass** Polauflagen (7-9, 7'-9') in den geraden Bereichen der magnetischen Tunnel angeordnet sind, die aus homogenem weichmagnetischen Material bestehen, aber nicht mit den magnetfelderzeugenden Teilen in den Kurvenbereichen bzw. deren Polauflagen magnetisch leitend verbunden sind.

3. Einrichtung nach einem der Ansprüche 1 oder 2, **dadurch gekennzeichnet, dass** als magnetischer Rückschluss wirkende Platten (4, 4'; 20) gleichzeitig eine Trägerfunktion für die längserstreckten Elektroden übernehmen.

4. Einrichtung nach mindestens einem der Ansprüche 1 bis 3, **dadurch gekennzeichnet, dass** zwischen den magnetfelderzeugenden Teilen und den Elektroden eine elektrische Isolierung (13) angeordnet ist.

5. Einrichtung nach mindestens einem der Ansprüche 1 bis 4, **dadurch gekennzeichnet, dass** auf der der jeweiligen Elektrode zugewandten Seite der Platten, die als Träger für die längserstreckten Elektroden dienen, Federkontakte für die Stromzuführung der jeweiligen Elektrode isoliert befestigt sind.

6. Einrichtung nach mindestens einem der Ansprüche 1 bis 5, **dadurch gekennzeichnet, dass** eine Folie (18, 18') aus weichmagnetischem Material an der Oberseite der längserstreckten Elektroden den magnetischen Feldverlauf so verändert, dass die zur Elektrodenoberfläche senkrecht stehende Komponente des magnetischen Feldes in jedem Tunnel in der Ebene auf den Elektroden befindlicher Targetplatten auf drei zueinander parallelen Linien gleich Null ist.

7. Einrichtung nach mindestens einem der Ansprüche 1 bis 6, **dadurch gekennzeichnet, dass** mindestens zwischen einigen benachbarten magnetfelderzeugenden Teilen Lücken (10) angeordnet sind.

8. Einrichtung nach Anspruch 7, **dadurch gekennzeichnet, dass** die Lücken (10) zwischen den magnetfelderzeugenden Teilen justierbar sind.

9. Einrichtung nach mindestens einem der Ansprüche 1 bis 8, **dadurch gekennzeichnet, dass** unter den Kurvenbereichen der magnetischen Tunnel anstelle von Polauflagen magnetfelderzeugende Teile zweireihig übereinander angeordnet sind.

10. Einrichtung nach mindestens einem der Ansprüche 3 bis 9, **dadurch gekennzeichnet, dass** die die Elektroden tragenden Platten als Formteil in der Art einer Wanne ausgeführt sind, welche im Bereich der magnetfelderzeugenden Teile Erhebungen mit angeschrägten Übergängen zum Boden der Wanne aufweisen.

11. Einrichtung nach mindestens einem der Ansprüche 3 bis 9, **dadurch gekennzeichnet, dass** die die Elektroden tragenden Platten aus einem flachen Trägerteil mit aufgesetzten angeschrägten Leisten (23-25) bestehen.

12. Einrichtung nach mindestens einem der Ansprüche 10 oder 11, **dadurch gekennzeichnet, dass** die die Elektroden tragenden Platten aus einem Bauteil (20) bestehen.

13. Einrichtung nach mindestens einem der Ansprüche 10 bis 12, **dadurch gekennzeichnet, dass** die die Elektroden tragenden Platten in einem Bauteil (20) zusammengefasst sind.

## Claims

1. An electrode device for the magnetic field guided, plasma supported separation of thin layers in a vacuum with several parallel longitudinal extended electrodes (4, 4', - 16, 16') with components of permanent magnets (1-3; 1' - 3') generating and forming the magnetic field, on the principle of the magnetron, which are dimensioned so that magnetic tunnels, with essentially the same cross-section and the same magnetic field strength are formed over parallel electrode areas, wherein at least one part of a magnetic field generating unit (1-3) is assigned to at least one longitudinally extended electrode (4) in isolation, **characterised in that that** part is designed so that its permanent magnetic arrangement (3) extending in the longitudinal direction of the electrode, which adjoins the magnetic field generating component (3') of an adjacent electrode (4') has a weaker magnetic field than the longitudinally extended permanent magnet arrangement (1) lying further out on the side opposing the adjacent electrode, wherein the part is arranged opposite the adjacent magnetic field generating component so that in the case of atomisation adequate uniform shaping of the magnetic tunnels over the straight areas of the erosion gulleys of these longitudinally extended electrodes, with adequate magnetic field strength, is only ensured by superposition with the magnetic fields of adjacent magnetic field generating components of other adjacent magnetic field generating components.

2. The device according to Claim 1, **characterised in that** pole supports (7-9; 7'-9') are arranged in the straight areas of the magnetic tunnels, which support consist of homogeneous soft magnetic material, but are not magnetically and conductively connected to the magnetic field generating parts in the curved areas or their pole supports.

3. The device according to Claim 1 or 2, **characterised in that** plates (4, 4; 20) acting as a magnetic reflux simultaneously perform a support function for the longitudinally extending electrodes.

4. The device according to at least one of Claims 1 to 3, **characterised in that** an electrical insulation (13) is arranged between the magnetic field generating parts and the electrodes.

5. The device according to at least one of Claims 1 to 4, **characterised in that** spring contacts for feeding current to each electrode are secured on the side of the plates acting as carriers for the longitudinally extended electrodes facing each electrode.

6. The device according to at least one of Claims 1 to 5, **characterised in that** a film (18; 18') of soft magnetic material on the upper side of the longitudinally extended electrodes modifies the course of the magnetic field so that the component of the magnetic field at right angles to the electrode surface is equal to zero in each tunnel in the same on three parallel lines in the same plane as the target plates on the electrodes.

7. The device according to at least one of Claims 1 to 6, **characterised in that** gaps (10) are arranged at least between some of the adjacent magnetic field generating parts.

8. The device according to Claim 7, **characterised in that** the gaps (10) between the magnetic field generating parts are adjustable.

9. The device according to at least one of Claims 1 to 8, **characterised in that** magnetic field generating parts are arranged in two rows, one above the other, under the curved areas of the magnetic tunnels instead of pole supports.

10. The device according to at least one of Claims 3 to 9, **characterised in that** the plates supporting the electrodes are designed as moulded parts in the manner of a trough, which plates are provided with elevations with bevelled transitions to the bottom of the trough in the region of the magnetic field generating parts.

11. The device according to at least one of Claims 3 to 9, **characterised in that** the plates supporting the electrodes consist of a flat supporting part with bevelled strips (23-25) applied to it.

12. The device according to at least one of Claims 10 or 11, **characterised in that** the plates supporting the electrodes consist of one component (20).

13. The device according to at least one of Claims 10 to 12, **characterised in that** the plates supporting the electrodes are assembled in one component (20).

## Revendications

1. Dispositif à électrodes pour le dépôt assisté au plasma et guidé par champ magnétique de couches minces sous vide, comportant plusieurs électrodes (4, 4', 16, 16') parallèles étirées en longueur avec des agrégats générant et formant le champ magnétique, composés d'aimants permanents (1-3, 1'-3) suivant le principe du flux magnétique, qui sont dimensionnés de manière à ce qu'il se forme sur des zones à électrodes s'étendant parallèlement des tunnels magnétiques sensiblement de même section transversale et de même intensité de champ magnétique, tandis qu'est associée à au moins une électrode étirée en longueur (4) isolée au moins une pièce d'une unité générant un champ magnétique (1-3), **caractérisé en ce que** cette pièce est réalisée de manière à ce que son dispositif d'aimants permanents (3) s'étendant dans le sens longitudinal de l'électrode et jouxtant l'agrégat générant un champ magnétique (3') d'une électrode voisine (4') présente un champ magnétique plus faible que le dispositif d'aimants permanents (1) étiré en longueur et placé plus loin sur le côté opposé à l'électrode voisine, tandis que la pièce est disposée par rapport à l'agrégat voisin générant le champ magnétique de manière à assurer, dans le cas d'une pulvérisation, seulement par superposition avec les champs magnétiques des agrégats voisins générant un champ magnétique des autres électrodes étirées en longueur, une expression suffisamment régulière des tunnels magnétiques sur les zones droites des fossés d'érosion de cette électrode étirée en longueur en cas d'intensité suffisante du champ magnétique.

2. Dispositif selon la revendication 1, **caractérisé en ce que**, dans les zones droites des tunnels magnétiques, sont disposées des garnitures polaires (7-9, 7'-9') qui sont composées de matière homogène modérément magnétique mais ne sont pas reliées avec conduction magnétique aux pièces générant un champ magnétique dans les zones de courbures ou leurs garnitures polaires.

3. Dispositif selon une des revendications 1 ou 2, **caractérisé en ce que** des plaques faisant office de blindage magnétique (4, 4' ; 20) assument en même temps une fonction porteuse pour les électrodes étirées en longueur.

4. Dispositif selon au moins une des revendications 1 à 3, **caractérisé en ce qu'**entre les pièces générant un champ magnétique et les électrodes, est disposée une isolation électrique (13).

5. Dispositif selon au moins une des revendications 1 à 4, **caractérisé en ce que**, sur le côté tourné vers l'électrode respective des plaques qui servent de support pour les électrodes étirées en longueur, des contacts à ressort pour l'alimentation en courant de l'électrode respective sont fixés avec une isolation.

6. Dispositif selon au moins une des revendications 1 à 5, **caractérisé en ce qu'**un film (18, 18') en matière modérément magnétique modifie l'évolution du champ magnétique sur la face supérieure des électrodes étirées en longueur, de sorte que la composante verticale par rapport à la surface des électrodes du champ magnétique est égale à zéro dans chaque tunnel dans le plan des plaques cibles se trouvant sur les électrodes sur trois lignes parallèles entre elles.

7. Dispositif selon au moins une des revendications 1 à 6, **caractérisé en ce qu'**au moins entre quelques pièces générant un champ magnétique, des intervalles (10) sont disposés.

8. Dispositif selon la revendication 7, **caractérisé en ce que** les intervalles (10) entre les pièces générant un champ magnétique sont réglables.

9. Dispositif selon au moins une des revendications 1 à 8, **caractérisé en ce que**, sous les zones de courbure des tunnels magnétiques, au lieu de garnitures polaires, des pièces générant un champ magnétique sont superposées sur deux rangées.

10. Dispositif selon au moins une des revendications 3 à 9, **caractérisé en ce que** les plaques supportant les électrodes sont réalisées sous forme de pièces moulées à la manière d'une bassine, qui présentent, au niveau des pièces générant un champ magnétique, des surélévations avec des transitions biseautées vers le fond de la bassine.

11. Dispositif selon au moins une des revendications 3 à 9, **caractérisé en ce que** les plaques supportant les électrodes sont composées d'une pièce porteuse plate sur laquelle sont posées des baguettes biseautées (23-25).

12. Dispositif selon au moins une des revendications 10 ou 11, **caractérisé en ce que** les plaques supportant les électrodes sont composées d'une pièce de construction (20).

13. Dispositif selon au moins une des revendications 10 à 12, **caractérisé en ce que** les plaques supportant les électrodes sont regroupées dans une pièce de construction (20).
